Europäisches Patentamt

European Patent Office

Office européen des brevets

(19)

(11) Publication number: **0 107 357**
**A2**

## (12) EUROPEAN PATENT APPLICATION

(21) Application number: **83305680.7**

(22) Date of filing: **23.09.83**

(51) Int. Cl.³: **H 01 L 31/18, H 01 L 31/02**

(30) Priority: **24.09.82 US 422688**

(43) Date of publication of application: **02.05.84**
Bulletin 84/18

(84) Designated Contracting States: **AT BE CH DE FR GB IT LI LU NL SE**

(71) Applicant: **ENERGY CONVERSION DEVICES, INC.,**
**1675 West Maple Road, Troy Michigan 48084 (US)**

(72) Inventor: **Izu, Masatsugu, 265 Manor Road, Birmingham Michigan 48008 (US)**
Inventor: **McGill, John Curtis, 227 Old Perch Road, Rochester Michigan 48063 (US)**
Inventor: **Czubatyj, Wolodymyr, 11434 McDougall, Hamtramck Michigan 48212 (US)**
Inventor: **Seguin, Richard William, 5270 Inverrary, Milford Michigan 48042 (US)**

(74) Representative: **Jackson, Peter Arthur et al, GILL JENNINGS & EVERY 53-64 Chancery Lane, London WC2A 1HN (GB)**

(54) Apparatus and method for making large area photovoltaic devices incorporating back reflectors.

(57) A system and method for making photovoltaic devices of the type including a plurality of amorphous semiconductor materials (16a–c, 18a–c, 20a–c) deposited onto a continuous conductive substrate (11) provides a reflector on the surface of the substrate (11) upon which the amorphous semiconductor materials (16a–c, 18a–c, 20a–c) are deposited to improve the efficiencies thereof. The reflectors can be either specular reflectors or diffuse reflectors. The specular reflectors are formed by vapor depositing a reflective material such as gold, silver, aluminum, copper, chromium, or molybdenum onto the substrate (11). The diffuse reflectors can be formed by imparting a roughened texture to the substrate surface (13) by, for example, sandblasting the substrate surface (13) or by sputtering a first reflective material thereon. A second reflective material (15) can be vapor deposited over the diffuse reflectors prior to the deposition of the amorphous semiconductor materials (16a–c, 18a–c, 20a–c). The reflectors can be formed either immediately prior to the deposition of the amorphous semiconductor materials (16a–c, 18a–c, 20a–c) or at a remote location at which the substrate (11) is wound onto a take-up roll and thereafter transported to a plurality of deposition chambers for the later deposition of the amorphous semiconductor materials (16a–c, 18a–c, 20a–c).

ENERGY CONVERSION DEVICES, INC.      Ref: 50/2256/02

APPARATUS AND METHOD FOR MAKING LARGE AREA
PHOTOVOLTAIC DEVICES INCORPORATING BACK REFLECTORS

This invention relates generally to methods and systems for making photovoltaic devices of the type including a plurality of amorphous semiconductor materials deposited onto a continuous conductive substrate having thereon a back reflector. The present invention more particularly relates to methods and systems for making such devices wherein the substrate has either a specular reflector or diffuse reflector for increasing the efficiencies of such devices. Additionally, the methods and systems of the present invention are adapted for the continuous production of such semiconductor photovoltaic devices on large area substrates.

This invention relates to methods and systems for continuously producing photovoltaic devices by depositing successive amorphous silicon alloy semiconductor layers on a substrate in each of a plurality of deposition chambers. The present invention more particularly relates to methods and systems to provide the devices, during the continuous production thereof, with back reflectors, either specular or diffuse, for increasing the efficiencies of the devices.

Recently, considerable efforts have been made to develop systems for depositing amorphous semiconductor alloys, each of which can encompass relatively large areas, and which can be doped to form p-type and n-type materials for the production of p-i-n type devices which are, in operation, substantially equivalent to their crystalline counterparts.

It is now possible to prepare amorphous silicon alloys by glow discharge techniques that have acceptable concentrations of localized states in the energy gaps thereof, and provide high quality electronic properties. This technique is fully described in U.S. Patent No. 4,226,898, Amorphous Semiconductors Equivalent to Crystalline Semiconductors, issued October 7, 1980 to Stanford R. Ovshinsky and Arun Madan. The preparation of such materials by vapor deposition is fully described in U.S. Patent No. 4,217,374, issued August 12, 1980 to Stanford R. Ovshinsky and Masatsugu Izu, under the same title. As disclosed in these patents, fluorine introduced into the amorphous silicon semiconductor alloys operates to substantially reduce the density of the localized states therein and facilitates the addition of other alloying materials, such as germanium.

The concept of utilizing multiple cells, to enhance photovoltaic device efficiency, was discussed at least as early as 1955 by E.D. Jackson, U.S. Patent No. 2,949,498 issued August 16, 1960. The multiple cell structures therein discussed utilized p-n junction crystalline semiconductor devices. Essentially the concept is directed to utilizing different band gap devices to more efficiently generate open circuit voltage (Voc.). The tandem cell device has two or more cells with the light directed serially through each cell, with a large band gap material followed by a smaller band gap material to absorb the light passed through the first cell or layer. The generated current from the cell is substantially matched so that the overall open circuit voltage can be maximized.

It is of obvious commercial importance to be able to mass produce photovoltaic devices. Unlike crystalline silicon which is limited to batch processing for the manufacture of solar cells, amorphous silicon alloys can be deposited in multiple layers over large area substrates to form solar cells in a high volume, continuous processing system. In such a system a substrate may be continuously advanced through a succession of deposition chambers, wherein each chamber is dedicated to the deposition of a specific material.

The composition of each amorphous layer is dependent upon the particular process gases introduced into each of the deposition chambers. The gases introduced into the deposition chambers are carefully controlled and isolated from the gases introduced into adjacent deposition chambers. More particularly, the deposition chambers are operatively connected by a relatively narrow gas gate passageway through which the web of substrate material passes and which is adapted to isolate the process gases introduced into adjacent deposition chambers. In making a solar cell of p-i-n type configuration, the first chamber is dedicated for depositing a p-type amorphous silicon alloy, the second chamber is dedicated for depositing an intrinsic amorphous silicon alloy, and the third chamber is dedicated for depositing an n-type amorphous silicon alloy.

To increase the efficiencies of the devices, the present invention provides methods and systems for forming back reflectors on the surface of the substrate upon which the amorphous semiconductor materials are deposited. The back reflector can be either a specular reflector or a diffuse reflector. With either type of reflector, light which has initially passed through the active region or regions of the devices but which is unabsorbed or unused is redirected through the active regions of the devices. This provides increased photon absorption and charge carrier generation in the active region or regions providing increased short circuit currents. In the case of a specular reflector, the unused light is generally redirected for one additional pass through the device active regions. In the case of a diffuse reflector, the light is redirected through the active regions at angles sufficient to cause the redirected light to be substantially confined within the devices. This provides multiple reflections of the redirected light in the active regions. As a result, both specular and diffuse back reflectors provide for increased short circuit currents and thus increased efficiencies. Another advantage of the diffuse reflector is that since the directed light passes through the active regions at an angle, the active region or regions can be made thinner to reduce charge carrier recombination while maintaining efficient charge carrier generation and collection. Unfortunately, back reflectors of the specular and diffuse type have only been provided in photovoltaic devices fabricated in the laboratory. While their advantages have been clearly demonstrated, methods and systems for incorporating these back reflectors in large area continuously produced devices have not been suggested in the prior art. It is to the end of providing methods and systems for the continuous high volume production of amorphous semiconductor photovoltaic devices incorporating either specular or diffuse back reflectors that the present invention is directed.

The present invention provides systems and methods for the high volume manufacturing of photovoltaic devices of the type including a plurality of amorphous semiconductor materials deposited onto a continuous conductive substrate and a reflector on the surface of the substrate upon which the amorphous semiconductor materials are deposited to improve the efficiencies thereof. The reflector can be either a specular reflector or a diffuse reflector. The specular reflector can be formed by vapor depositing a reflective material such as gold, silver, aluminum, copper, chromium, or molybdenum onto the substrate. The diffuse reflector can be formed by imparting a roughened texture to the substrate surface by, for example, sandblasting the substrate surface or by sputtering a first reflective material thereon. A second reflective material can be vapor deposited over the diffuse reflector prior to the deposition of the amorphous semiconductor materials. The reflectors can be formed either immediately prior to the deposition of the amorphous semiconductor materials or at a remote location whereat the substrate is wound onto a take-up roll and thereafter transported to a plurality of deposition chambers for the later deposition of the amorphous semiconductor materials.

Accordingly, a first object of the invention is to provide a system for making photovoltaic devices of the type including a plurality of amorphous semiconductor materials deposited onto a continuous conductive substrate, the system includes a supply source of the continuous conductive substrate, a plurality of deposition chambers, each chamber arranged to deposit a respective one of the semiconductor materials onto the substrate as the substrate is advanced therethrough, and is characterized by substrate surface preparation means disposed between the substrate supply source and the deposition chambers for forming a reflector on the surface of the substrate upon which the amorphous semiconductor materials are deposited.

A second object of the invention is to provide a method of making a photovoltaic device of the type including a plurality of amorphous semiconductor materials deposited on a continuous conductive substrate. The method is characterized by the steps of forming a reflector on the surface of the substrate and depositing a plurality of amorphous semiconductor materials onto the reflector by advancing the substrate through each of a corresponding plurality of amorphous semiconductor deposition chambers.

The preferred embodiment of this invention will now be described by way of example, with referenced to the drawings accompanying this specification in which:

Fig. 1 is a fragmentary, cross-sectional view of a tandem or cascade photovoltaic device comprising a plurality of p-i-n type cells, each layer of the cells formed from an amorphous semiconductor alloy in accordance with the principles of the present invention;

Fig. 2 is a diagrammatic representation of a multiple glow discharge chamber deposition system adapted for the continuous production of the photovoltaic devices shown in Fig. 1, which system includes means for providing the devices with back

-7-

reflectors in accordance with the present invention; and

Figs. 3-5 diagrammatically illustrate the manner in which diffuse or specular reflectors can be formed on a continuous substrate web at a location remote from the amorphous semiconductor continuous deposition system.

I.  The Photovoltaic Cell

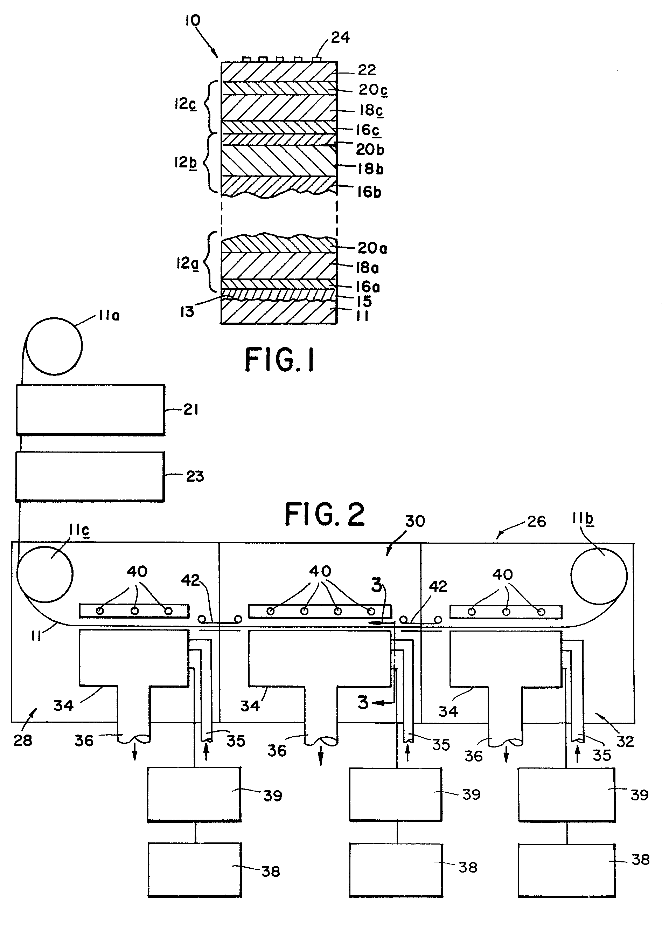

Referring now to the drawings and particularly to Fig. 1, a photovoltaic cell, formed of a plurality of successive p-i-n layers, each of which includes an amorphous semiconductor alloy and including a substrate 11 prepared in accordance with the present invention, is shown generally by the numeral 10.  It is for the production of this type of photovoltaic device 10, wherein the substrate 11 of the device is provided with a specular or diffuse reflector before the amorphous alloy layers are continuously deposited onto the moving web of substrate material 11 in successive isolated deposition chambers, that the present invention is most applicable.

More particularly, Fig. 1 shows a p-i-n type photovoltaic device such as a solar cell made up of individual p-i-n type cells 12a, 12b, and 12c. Below the lowermost cell 12a is a substrate 11 which may be formed from a metallic material such as stainless steel, aluminum, tantalum, molybdenum, or chrome.  The substrate 11 of the device 10 illustrated in Fig. 1 includes a diffuse reflector formed in accordance with the present invention.  To that end, the substrate 11 has a roughened surface 13 and a thin layer 15 of reflective material over the roughened surface.  The layer 15 can be formed from silver, aluminum,

-8-

gold, or copper and can be deposited by vapor deposition. The roughened surface 13 can be formed by either sandblasting the substrate 11 or by sputter depositing a reflective material, such as aluminum, over the substrate. In either form, the resulting diffuse reflector will reflect incident light not absorbed by the active regions of the device during the first pass therethrough back into the device at angles sufficient to substantially totally confine the light within the device. This provides multiple passes of the light through the active regions, which, as previously mentioned, results in increased charge carrier generation and short circuit for increasing the efficiency of the device.

Also in accordance with the present invention, the device 10 can be provided with a specular reflector instead of the diffuse reflector as illustrated. Here, the roughening step is eliminated and only the reflective layer 15 need be deposited. The reflective layer can be formed by vapor depositing silver, gold, copper, chromium, molybdenum, or aluminum, for example, over the substrate 11. This form of reflector also reflects light not absorbed during the initial pass through the active regions of the device back through the device. As opposed to the diffuse reflector wherein multiple passes of the light are obtained, the specular reflector provides for only one additional pass. However, since amorphous silicon alloys are good light absorbers, the one additional pass of the unabsorbed light through the device also provides a significant increase in short circuit current and device efficiency.

Each of the cells 12a, 12b and 12c are fabricated with an amorphous alloy body containing at least a silicon alloy. Each of the alloy bodies includes a p-type conductivity region or layer 16a, 16b and 16c; an intrinsic region or layer 18a, 18b and 18c; and an n-type conductivity region or layer 20a, 20b and 20c. As illustrated, cell 12b is an intermediate cell and, as indicated in Fig. 1, additional intermediate cells may be stacked atop the illustrated cells without departing from the spirit or scope of the present invention. Also, although p-i-n cells are illustrated, the present invention also pertains to multiple n-i-p cells as well.

It is to be understood that following the deposition of the semiconductor alloy layers, a further deposition process may be either performed in a separate environment or as a part of a continuous process. In this step, a TCO (transparent conductive oxide) layer 22 is added. An electrode grid 24 may be added to the device where the cell is of a sufficiently large area, or if the conductivity of the TCO layer 22 is insufficient. The grid 24 shortens the carrier path and increases the collection efficiency.

II.  The Continuous Processing System

Turning now to Fig. 2, a diagrammatic representation of a multiple chamber glow discharge deposition apparatus for the continuous production of photovoltaic cells is generally illustrated by the reference numeral 26. The apparatus 26 includes a substrate surface preparation chamber 21, a metal vapor deposition chamber 23, and a plurality of isolated, dedicated deposition chambers 28, 30 and 32, each chamber of which is interconnected

-10-

by a gas gate through which a sweep gas flows in a nonviolant manner.

The apparatus 26 is adapted to produce a high volume of large area, amorphous photovoltaic cells having a p-i-n configuration on the deposition surface of a substrate material 11 which is processed to include one of the back reflectors previously described and continually fed therethrough. Prior to being continuously advanced through the deposition chambers to be described hereafter, the substrate 11 is first provided with either a specular or diffuse back reflector. To that end, the substrate web is advanced from a supply roll 11a into a substrate surface preparation chamber 21. In this chamber 21, the substrate is provided with a roughened surface.

In accordance with one embodiment of the present invention, the chamber 21 can comprise a sandblasting chamber. Sandblasting, well known to technologies other than photovoltaics, includes projecting fine granular particles against a surface to provide the surface with a roughened texture. Here, sandblasting can be used to provide the surface of the substrate, formed from a metal such as stainless steel, aluminum, tantalum, molybdenum or chrome with a roughened texture to form a diffuse reflecting surface.

In accordance with another embodiment of the present invention, the chamber 21 can comprise a sputtering chamber. Here, a reflective material can be sputtered onto the surface of the substrate in a manner which results in the formation of a roughened surface. For example, aluminum can be sputtered by radio frequency diode sputtering at a frequency of 13.56 Megahertz. Preferably, the system includes an aluminum target of high purity which is sputtered at a power density of approximately 2 watts per square centimeter. The chamber 21 is preferably maintained at a pressure of about .006 Torr and contains about 1 to 8 percent and preferably 5 percent hydrogen diluted in argon gas which is flowed into the chamber at a rate of 15 standard cubic centimeters per minute (SCCM). Under these conditions, a textured aluminum layer can be formed at a rate of 45.7 angstroms per minute. The aluminum layer thus formed can have a thickness of about 1600 angstroms requiring a deposition time of about 35 minutes.

Prior to the deposition of the textured aluminum layer, the substrate 11 can first be subjected to an initial cleaning step. To initially clean the substrate surface, the substrate can first be advanced through another sputtering chamber wherein the substrate is sputter etched under the same power density and pressure as previously mentioned.

After the substrate is provided with the roughened or textured surface, it is then advanced through a metal vapor deposition chamber 23. Here, a reflective metal such as silver, aluminum, gold, or copper is deposited over the textured surface. Although the roughened substrate surface itself is capable of acting as a sufficient diffuse reflector, this additional metal deposition can enhance the reflection efficiency of the diffuse reflector. Once the substrate 11 is provided with the diffuse reflector as described above, the substrate is then ready to be advanced in the amorphous silicon alloy deposition chamber.

0107357

-12-

In accordance with another embodiment of the present invention, the substrate 11 can be provided with a specular reflector. To that end the chamber 21 can comprise a metal vapor deposition chamber for depositing, for example, a layer of silver, gold, copper, chromium, molybdenum, or aluminum onto the substrate. In this event, the chamber 23 can either be eliminated or used to deposit a transparent conductor of indium tin oxide, cadmium stannate, doped tin oxide, vanadium oxide, germanium tin oxide, or cuprous oxide over the vapor deposited reflective metal. Such transparent conductors provide enhanced reflection of light from the reflective metals.

To deposit the amorphous alloy layers required for producing multiple p-i-n type layer cells, the apparatus 26 includes at least one triad of deposition chambers. Each triad comprises: a first deposition chamber 28 in which a p-type conductivity amorphous alloy layer is deposited onto the deposition surface of the substrate 11 as the substrate 11 passes therethrough; a second deposition chamber 30 in which an intrinsic amorphous alloy layer is deposited atop the p-type alloy layer on the deposition surface of the substrate 11 as the substrate 11 passes therethrough; and a third deposition chamber 32 in which an n-type conductivity alloy layer is deposited atop the intrinsic layer on the deposition surface of the substrate 11 as the substrate 11 passes therethrough. It should be apparent that although only one triad of deposition chambers has been illustrated, additional triads or additional individual chambers may be added to the apparatus to provide the machine with the capability of producing photovoltaic cells having any number of amorphous p-i-n type layers.

The substrate 11 is advanced into the first chamber 28 over an idler roller 11c and continuously through the other chambers to a take-up core 11b shown in the deposition chamber 32. In reality, the cores 11a and 11b would be housed in separate chambers operatively connected to the deposition chambers.

Each deposition chamber 28, 30 and 32 of the triad is adapted to deposit a single amorphous silicon alloy, by glow discharge deposition onto the conductive substrate 11. To that end, each of the deposition chambers 28, 30 and 32 includes: an electrode assembly 34; a gas supply conduit 35; an out-gassing conduit 36; a radio frequency generator 38; a tuning network 39; a plurality of radiant heating elements 40; and a gas gate 42 operatively connecting the intrinsic deposition chamber (30) to each of the dopant chambers 28 and 32. The supply conduits 35 are operatively associated with the respective electrode assemblies 34 to deliver process gas mixtures to the plasma regions created in each deposition chamber.

The radio frequency generators 38 operate in conjunction with the electrode assemblies 34, the radiant heaters 40 and the grounded substrate 11 to form the plasma regions by dissociating the elemental reaction gases entering the deposition chambers into deposition species. The deposition species are then deposited onto a surface of the substrate 11 as amorphous semiconductor layers.

The tuning networks 39 match the output impedance of the generators 38 to the input impedance of the electrode assemblies 34. This provides efficient power transfer between the generators 39 and the electrode assemblies 34.

To form the photovoltaic cell 10 illustrated in Fig. 1, a p-type amorphous silicon layer is deposited onto the substrate 11 in the deposition chamber 28, an intrinsic amorphous silicon alloy layer is deposited atop the p-type layer in the deposition chamber 30 and an n-type amorphous silicon alloy layer is deposited atop the intrinsic layer in the deposition chamber 32. As a result, the apparatus 26 deposits at least three amorphous silicon alloy layers onto the substrate 11 wherein the intrinsic layer deposited in deposition chamber 30 differs in composition from the layers deposited in deposition chambers 28 and 32 by the absence of at least one element which will be referred to as the dopant or doping species.

It is important that each of the alloy layers (and particularly the intrinsic layer) deposited onto a surface of the substrate 11 be of high purity in order to produce high efficiency photovoltaic devices 10. The gas gates 42 substantially prevent the back diffusion of process gases from the dopant chambers 28 and 32 into the intrinsic deposition chamber 30.

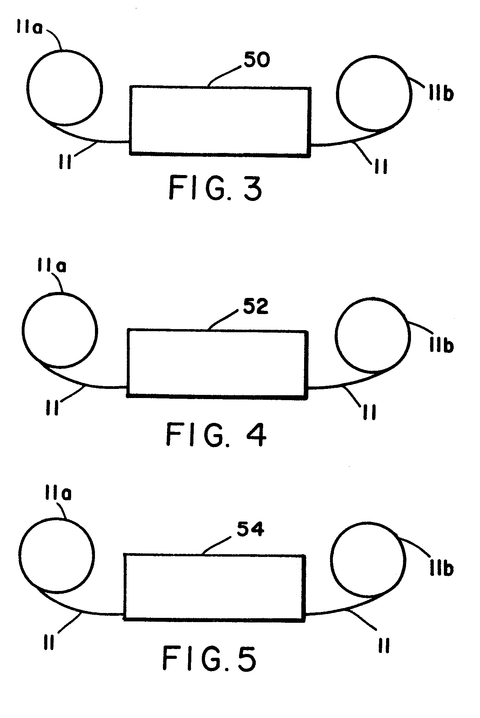

Referring now to Figs. 3 through 5, they illustrate that the substrate 11 can be provided with the specular or diffuse reflectors at a location remote from the glow discharge continuous deposition chambers in accordance with the present invention. Fig. 3 illustrates a metal vapor deposition chamber 50 for forming a specular reflector onto a substrate 11. The substrate is continuously advanced from a supply core 11a, through the chamber 50, and onto a take-up core 11b. Once the substrate processing is completed, the core 11b is then transported to the amorphous silicon alloy deposition system.  As in previous embodiments, the specular reflector provided by the chamber 50 can be a layer of, for example, silver, gold, chromium, molybdenum, or aluminum vapor deposited onto the substrate 11.

Figs. 4 and 5 illustrate that the substrate 11 can be provided with a textured or roughened surface in a process remote from the amorphous silicon alloy deposition system.  In Fig. 4, a sputtering chamber 52 is utilized to sputter aluminum onto a continuous substrate 11.  The sputtering parameters can be the same as previously described.  In Fig. 5, a sandblasting chamber 54 is alternatively employed.  After the roughened surface is formed on the substrate, the take-up cores 11b can be transferred to the vapor deposition chamber 50 of Fig. 3 to receive a layer of reflective metal such as silver, aluminum, gold, or copper.  Once this step is completed, the substrate is ready for transport to the amorphous silicon alloy deposition system.

-16-

CLAIMS

1. A system for making photovoltaic devices of the type including a plurality of amorphous semiconductor materials deposited onto a continuous conductive substrate, said system characterized by:

a supply source (11a) of said continuous conductive substrate (11);

a plurality of deposition chambers (28, 30, 32), each said chamber arranged to deposit a respective one of said semiconductor materials (16a-c, 18a-c, 20a-c) onto said substrate as said substrate is advanced therethrough; and

substrate surface preparation means (21) disposed between said substrate supply source and said deposition chambers for forming a reflector (15) on the surface of said substrate upon which said amorphous semiconductor materials are deposited.

2. A system for preparing the surface of a continuous conductive substrate upon which a plurality of amorphous semiconductor materials are to be deposited to form a photovoltaic device, said system characterized by:

substrate surface preparation means (21) for forming a reflector on the surface of said substrate (11) upon which said amorphous semiconductor materials (16a-c, 18a-c, 20a-c) are to be deposited.

3. A system according to any one of claims 1 or 2 further characterized by said substrate surface preparation means (21) is arranged to form a specular reflector (15) on the surface of said substrate (11) upon which said amorphous semiconductor materials (16a-c, 18a-c, 20a-c) are deposited.

4. A system according to claim 3 further characterized by said substrate preparation means comprises vapor deposition means (50) for depositing a reflective material on said surface of said substrate (11).

5. A system according to claim 4 further characterized by said substrate preparation means comprises means (50) for vapor depositing silver, gold, copper, chromium, molybdenum, or aluminum onto said substrate surface.

6. A system according to any one of claims 1 or 2 further characterized by said substrate preparation means (21) is arranged to form a diffuse reflector on the surface of said substrate (11) upon which said amorphous semiconductor materials (16a-c, 18a-c, 20a-c) are deposited.

7. A system according to claim 6 further characterized by said substrate surface preparation means comprises a sandblasting chamber (54) for roughening said substrate surface (13) to form said diffuse reflector.

8. A system according to claim 6 further characterized by said substrate surface preparation means comprises a sputtering deposition chamber (52) for sputtering a first reflective material onto said substrate surface (13) to form said diffuse reflector.

9. A system according to claim 8 further characterized by said sputtering deposition chamber (52) is arranged for sputtering aluminum onto said substrate surface (13).

10. A system according to any one of claims 7 or 8 further characterized by means (23) between said substrate preparation means (21) and said deposition chambers (28, 30, 32) for depositing a

-18-

second reflective material (15) over said substrate diffuse reflector (13).

11. A system according to claim 10 further characterized by said reflective material deposition means comprises a vapor deposition chamber (23).

12. A system according to claim 11 further characterized by said vapor deposition chamber (23) is arranged to vapor deposit silver, aluminum, gold, or copper over said substrate diffuse reflector (13).

13. A method of making a photovoltaic device of the type comprising a plurality of amorphous semiconductor materials deposited on a continuous conductive substrate, said method characterized by the steps of:

forming a reflector on the surface of said substrate; and

depositing a plurality of amorphous semiconductor materials onto said reflector by advancing said substrate through each of a corresponding plurality of amorphous semiconductor deposition chambers.

14. A method according to claim 13 further characterized by said step of forming said reflector includes depositing a reflective material onto said substrate to form a specular reflector.

15. A method according to claim 14 further characterized by said step of depositing said reflective material onto said substrate includes vapor depositing said reflective material onto said substrate.

16. A method according to claim 15 further characterized by said reflective material is gold, silver, aluminum, copper, chromium, or molybdenum.

17. A method according to claim 14 further characterized by said step of forming said reflector on said substrate includes the step of continuously advancing said substrate through a vapor deposition chamber to deposit said reflective material thereon immediately prior to the step of advancing said substrate through said plurality of amorphous semiconductor deposition chambers.

18. A method according to claim 14 further characterized by said step of forming said reflector on said substrate includes the steps of depositing said reflective material onto said substrate, winding said substrate onto a take-up roll and thereafter transporting said take-up roll to said plurality of amorphous semiconductor deposition chambers.

19. A method according to claim 13 further characterized by said step of forming said reflector includes forming a diffuse reflector on said substrate.

20. A method according to claim 19 further characterized by said step of forming said diffuse reflector on said substrate includes the step of imparting a roughened texture to said substrate surface.

21. A method according to claim 20 further characterized by said step of imparting a roughened texture to said substrate includes the step of sandblasting said substrate to form said diffuse reflector.

22. A method according to claim 20 further characterized by wherein said step of imparting a roughened texture to said substrate includes the step of sputtering a first reflective material onto said substrate to form said diffuse reflector.

23. A method according to claim 22 further characterized by wherein said first reflective material is aluminum.

24. A method according to any one of claims 21 or 22 characterized by the further step of depositing a second reflective material on said diffuse reflector.

25. A method according to claim 24 further characterized by including the step of vapor depositing said second reflective material on said diffuse reflector.

26. A method according to claim 25 further characterized by said second reflective material is gold, silver, copper, aluminum, chromium, or molybdenum.

27. A method according to claim 19 further characterized by said step of forming said diffuse reflector is performed immediately prior to the step of advancing said substrate through said plurality of amorphous semiconductor chambers.

28. A method according to claim 19 further characterized by said step of forming said diffuse reflector is performed at a location remote from said amorphous semiconductor deposition chambers and includes winding said substrate into a take-up roll and thereafter transporting said take-up roll to said plurality of amorphous semiconductor deposition chambers.

29. A method according to claim 28 characterized by the further step of depositing a second reflective material over said diffuse reflector prior to winding said substrate into said take-up roll.

-21-

30. A method according to claim 29 further characterized by said step of depositing said second reflective material over said diffuse reflector includes vapor depositing said second reflective material.

31. A method according to claim 30 further characterized by said second reflective material is silver, gold, copper, aluminum, chromium, or molybdenum.

32. A method according to claim 23 further characterized by said step of sputtering said aluminum onto said substrate includes the steps of providing a sputtering chamber having an aluminum target therein, maintaining a deposition pressure of about .006 Torr within said chamber, introducing a gas mixture of 1 to 8 percent hydrogen diluted in argon into said chamber at a flow rate of about 15 SCCM, and maintaining a radio frequency energy power density of about 2 watts per square centimeter within said chamber.

FIG. 1

FIG. 2

0107357

2/2

11a

50

11b

11

11

FIG. 3

11a

52

11b

11

11

FIG. 4

11a

54

11b

11

11

FIG.5